# EUROPÄISCHE PATENTSCHRIFT

(11) **EP 2 347 029 B1**
(45) Veröffentlichungstag und Bekanntmachung des Hinweises auf die Patenterteilung: **15.01.2020**
(21) Anmeldenummer: 09771279.8
(22) Anmeldetag: 09.10.2009
(51) Int. Cl.: B01J 37/02, C23C 16/40, C23C 16/455

(54) **VERFAHREN ZUR HERSTELLUNG PHOTOKATALYTISCH AKTIVER TITANDIOXIDSCHICHTEN**
METHOD FOR PRODUCING PHOTOCATALYTICALLY ACTIVE TITANIUM DIOXIDE LAYERS
PROCÉDÉ POUR PRODUIRE DES COUCHES DE DIOXYDE DE TITANE À ACTION PHOTOCATALYTIQUE

(30) Priorität: 14.10.2008 DE 102008052098
(43) Veröffentlichungstag der Anmeldung: 27.07.2011
(73) Patentinhaber: Fraunhofer-Gesellschaft zur Förderung der angewandten Forschung e.V., 80686 München (DE)
(72) Erfinder: ABENDROTH, Thomas, 01069 Dresden (DE); ALTHUES, Holger, 01309 Dresden (DE); KASKEL, Stefan, 01159 Dresden (DE); DANI, Ines, 09244 Lichtenau (DE)
(74) Vertreter: Pfenning, Meinig & Partner mbB
(86) Internationale Anmeldenummer: PCT/DE2009/001474
(87) Internationale Veröffentlichungsnummer: WO 2010/043215

(56) Entgegenhaltungen:
- DE-A1-102004 045 321
- US-A- 6 113 983
- US-B1- 6 268 019
- US-B1- 6 921 707
- UUSTARE T ET AL: "Morphology and structure of TiO2 thin films grown by atomic layer deposition" JOURNAL OF CRYSTAL GROWTH, ELSEVIER, AMSTERDAM, NL, Bd. 148, Nr. 3, 1. März 1995 (1995-03-01), Seiten 268-275, XP004010729 ISSN: 0022-0248
- KAMATA K ET AL: "RAPID FORMATION OF TIO2 FILMS BY A CONVENTIONAL CVD METHOD", JOURNAL OF MATERIALS SCIENCE LETTERS, CHAPMAN AND HALL LTD. LONDON, GB, vol. 9, no. 3, 1 March 1990 (1990-03-01), pages 316-319, XP000159766, ISSN: 0261-8028, DOI: 10.1007/BF00725836

## Beschreibung

Die Erfindung betrifft ein Verfahren zur Herstellung photokatalytisch aktiver Titandioxidschichten auf Substratoberflächen. Es können dabei unterschiedlichste Substratwerkstoffe beschichtet werden, die auch temperaturempfindlich sein können.

Der Einsatz so beschichteter Elemente ist vielfältig möglich und es können vorteilhafte Wirkungen ausgenutzt werden. So kann ein Selbstreinigungseffekt bei Fenstern oder Fassadenelementen ausgenutzt werden. Bei Wandverkleidungen oder in Fahrzeugkabinen zur Luftreinigung ist eine selbständige Sterilisierung nutzbar. Es können organische Verbindungen durch Reaktion mit Sauerstoff zu Kohlenstoffdioxid und Wasser oxidiert werden, wenn die beschichtete Oberfläche geeigneter elektromagnetischer Strahlung ausgesetzt wird. Photokatalytisch aktives Titandioxid weist hierfür einen hohen Anteil an Titandioxid in der Anatas-Modifikation auf. In Folge einer Bandlücke bei 3,2 eV kann elektromagnetische Strahlung mit Wellenlängen unterhalb von 388 nm zur Anregung von Elektronen-Loch-Paaren zur Initiierung der Reaktionen genutzt werden.

So beschichtete Oberflächen können auch hydrophil sein, so dass eine Wassertropfenbildung an der Oberfläche vermieden werden kann und wegen der Wasserfilmbildung ein Beschlagschutz erreichbar ist.

Außerdem kann mikrobiologisches Wachstum verhindert, zumindest jedoch behindert werden.

Für die Ausbildung von den in Rede stehenden Titandioxidschichten sind unterschiedliche Verfahren bekannt und werden auch eingesetzt. In vielen Fällen ist die Herstellung jedoch mit hohem Aufwand und Kosten verbunden. So werden solche Beschichtungen mit unterschiedlichsten PVD-Verfahren ausgebildet. Dabei ist der Aufwand wegen der erforderlichen Vakuumtechnik aber erheblich.

Sol-Gel Verfahren und thermische Oxidationsverfahren erfordern sehr hohe Temperaturen und können daher nicht für die Beschichtung aller Werkstoffe eingesetzt werden. Der Zeitaufwand hierfür ist ebenfalls hoch. Die Schichten können auch thermisch aufgespritzt werden, was aber eine geringe Schichtqualität und raue Oberflächen hervorruft.

CVD-Verfahren unter Vakuumbedingungen mit und ohne Plasma- oder Photonenunterstützung weisen ähnliche Nachteile, wie die PVD-Verfahren auf.

Ein Ansatz ein CVD-Verfahren bei normalem Atmosphärendruck einzusetzen ist aus EP 1 650 325 A1 bekannt. Dabei soll insbesondere eine Pulverbildung vermieden werden, die normalerweise bei solchen Verfahren nicht zu vermeiden ist und die Anlagentechnik sowie die Schichtqualität beeinträchtigt. Es wird darin vorgeschlagen mit Hilfe einer Gasphasen-Hydrolyse eine Metalloxidschicht auf einer Oberfläche auszubilden. Für Titandioxidschichten sollen dabei insbesondere gasförmiges TiCl₄ und Wasserdampf als Gase eingesetzt werden, die bei Kontakt chemisch miteinander reagieren. Zur Vermeidung der Pulverbildung wird darin vorgeschlagen eine verkürzte Kontaktzeit der beiden miteinander reagierenden Gase auszunutzen, die bei maximal 1s liegen soll. Dadurch kann auf der Oberfläche eine Schicht mit Titan erhalten werden, die nachfolgend bei Temperaturen oberhalb 300 °C noch kalziniert und dadurch dann erst die letztendlich photokatalytisch aktive Titandioxidschicht erhalten werden kann.

Es liegt auf der Hand, dass der zusätzliche Verfahrensschritt - Kalzinieren - den Herstellungsaufwand erhöht und auch wegen der hierfür erforderlichen Temperaturen nicht alle Werkstoffe so beschichtet werden können.

Von UUSTARE et al sind in "Morphology and structure of TiO2 thin films grown by atomic layer deposition"; JOURNAL OF CRYSTAL GROWTH; ELSEWERE, AMSTERDAM; NL; Bd. 3; 1. März 1995; Seiten 268-275; XP004010729ISSN:0022-0248 Möglichkeiten für die Beschichtung von TiO₂ unter Einsatz von TiCl₄ und Wasser bei Temperaturen im Bereich 100 °C bis 500 °C beschrieben.

Die DE 10 2004 045 321 A1 betrifft ein Normaldruck-CVD-Verfahren und Vorrichtungen zum Herstellen eines photoaktiven Überzugs, bei dem ein, einen Precursor enthaltendes Gasgemisch verwendet wird. Das Gasgemisch soll beim Auftreffen auf ein Substrat eine Temperatur oberhalb 500 °C aufweisen und schnell auf das Substrat geleitet werden.

In US 6,113,983 A ist ein Verfahren zur Ausbildung metallischer und keramischer Strukturen mit metallischen Halogeniden und alkalischen Metallen beschrieben.

Von K. Kamata et al. sind in "Rapid formation of TiO2 films by conventional CVD method", Journal of materials science letters, Chapmann and Hall Ltd., London, Gb, Bd. 9, Nr. 3, 01. März 1990, Seiten 316-319, XP000159766, ISNN: 0261-8028, DOI: 10.1007/BF00725836 Möglichkeiten für die Ausbildung von Schichten aus Titandioxid beschrieben, bei denen Titantetraisopropoxid (TTI) mit Sauerstoff eingesetzt und auf ein erwärmtes zu beschichtendes Substrat gerichtet werden.

Aus US 6, 268,019 B1 ist ein Verfahren bekannt, bei dem zur Ausbildung von Titandioxidschichten TiCl₄ mit einem erwärmten Trägergas und zusätzlich bis zum Erreichen einer Mischzone ein Gemisch aus Wasser, einer Sauerstoffquelle und einer Fluor enthaltenden Verbindung getrennt voneinander zugeführt werden. Das in der Mischzone erhaltene Gemisch wird dann auf ein erwärmtes Substrat gerichtet und die chemischen Reaktionen können ausgehend von der Mischzone bis zum Erreichen der Substratoberfläche ablaufen.

Es ist daher Aufgabe der Erfindung den Aufwand für die Herstellung photokatalytisch aktiver Titandioxidschichten zu reduzieren und die Auswahl für die Beschichtung geeigneter Substratwerkstoffe zu vergrößern.

Erfindungsgemäß wird diese Aufgabe mit einem Verfahren, das die Merkmale des Anspruchs 1 aufweist, gelöst. Vorteilhafte Ausgestaltungen und Weiterbildungen der Erfindung können mit in untergeordneten Ansprüchen bezeichneten Merkmalen realisiert werden.

Ausgehend von der aus EP 1 650 325 A1 bekannten technischen Lehre hat es sich aber überraschend gezeigt, dass photokatalytisch aktive Titandioxidschichten allein mit Gasphasen-Hydrolyse als CVD-Verfahren erhalten werden können, wenn die hierfür genutzten Gase, nämlich eine in der Gasphase vorliegende Titanverbindung und Wasserdampf so zugeführt werden, dass sie erst voneinander getrennt sind und erst kurz vor der Oberfläche auf der die Schicht ausgebildet werden soll zusammengeführt werden und die Kontaktzeit bis zum Auftreffen auf die Oberfläche um Größenordnungen verringert wird. Die beiden gasförmigen Komponenten werden dabei so zugeführt, dass sie eine Strömungsgeschwindigkeit von mindestens 0,5 m/s, bevorzugt mindestens 2 m/s aufweisen und die Zeit zwischen dem ersten Kontakt der beiden Gase bis zum Auftreffen auf die zu beschichtende Substratoberfläche kleiner als 0,05 s, bevorzugt kleiner 0,001 s gehalten wird.

Dies kann neben der hohen Strömungsgeschwindigkeit dadurch erreicht werden, dass der Abstand zwischen Austrittsöffnungen von Düsen einer Vorrichtung zur Zuführung der Gase, durch die zumindest eines der beiden miteinander reagierenden Gase (Titanverbindung oder Wasserdampf) zugeführt wird, bis zur zu beschichtenden Oberfläche klein gehalten wird. In der Regel werden dies wenige Millimeter sein. Dabei können Austrittsöffnungen von Düsen für die gasförmige Titanverbindung oder Austrittsöffnungen für Wasserdampf diesen kleinen Abstand aufweisen. Es besteht aber auch die Möglichkeit den Abstand von Austrittsöffnungen für diese beiden Gase so klein zu halten. Dabei kann der Abstand der Austrittsöffnungen zur Substratoberfläche gleich, nur geringfügig voneinander bzw. auch sehr weit voneinander entfernt angeordnet sein. Es soll lediglich die mögliche Reaktionszeit so verkürzt werden. Der maximale Abstand einer Austrittsöffnung, die die zur Verfügung stehende Reaktionszeit beeinflusst, sollte 20 mm, bevorzugt 10 mm nicht überschreiten.

Mit dem erfindungsgemäßen Verfahren ist es möglich, die gewünschten photokatalytisch aktiven Titandioxidschichten in einem Zug herzustellen. Es ist keine weitere Nachbehandlung mehr erforderlich und die Schichten sind unmittelbar im Anschluss nutzbar. Es ist lediglich eine Vorerwärmung der zu beschichtenden Substrate erforderlich, wie dies auch bei dem bereits bekannten Verfahren der Fall war, um eine Kondensation der beiden miteinander reagierenden Gase vor dem Auftreffen auf die Substratoberfläche zu vermeiden. Die hierfür erforderlichen Temperaturen sind aber deutlich kleiner, als dies für die Kalzinierung der Fall ist. So können beispielsweise auch Polymere oder auch Papier neben anderen Werkstoffen erfindungsgemäß beschichtet werden. Es können auch Folien so beschichtet werden.

Neben den an sich bekannten geeigneten Titanverbindungen, wie z.B. auch TiCl₄, hat es sich als besonders bevorzugt herausgestellt, Tetraisopropylorthotitanat, nachfolgend als TTIP bezeichnet, als geeignete Titanverbindung einzusetzen. Es können auch Titanalkoxide bzw. Titanalkoholate, wie beispielsweise Titanethoxid -Ti(C₂H₅O)₄-, Titann-butoxid -Ti(n-C₄H₉O)₄- oder Titan-t-butoxid - Ti(t-C₄H₉O)₄ eingesetzt werden.

Die beiden gasförmigen Komponenten können mit einem zusätzlichen Trägergas zugeführt werden. Die beiden Gase können so verdünnt werden. Dabei können Wasserdampf mit dem Trägergas als Gemisch, die Titanverbindung mit Trägergas als Gemisch zugeführt werden. Ein Trägergas soll ein inertes Gas, wie z.B. Stickstoff oder Argon sein. Es können weitere gasförmige Komponenten zugemischt werden, durch die eine Dotierung der Titandioxidschicht erreichbar ist. Eine hierfür geeignete chemische Verbindung ist z.B. Niob(V)-Ethoxid. Durch eine Niobdotierung kann eine erhöhte elektrische Leitfähigkeit einer Titandioxidschicht erreicht werden.

Die jeweiligen Volumenströme der miteinander reagierenden beiden Gaskomponenten sollten für die Ausbildung der Schicht so eingestellt sein, dass Wasser im Überschuss vorhanden ist. Zumindest sollte ein Mol-Verhältnis von 2 zu 1 für Wasser und Titanverbindung eingehalten sein. Es ist ein Mol-Verhältnis von 10 zu 1 bevorzugt, wobei in diesem Fall nicht das gesamte Wasser reagiert.

Wird TTIP als Titanverbindung eingesetzt kann folgende Gesamtreaktion über mehrere Zwischenstufen ablaufen:

Ti(OC₃H₇)₄ + 2H₂O → TiO₂ + 4 HOC₃H₇

Die erste Teilreaktion ist die Hydrolyse des TTIP:

Ti(OC₃H₇)₄ + 4H₂O → Ti(OH)₄ + 4 HOC₃H₇

Es kann dabei angenommen werden, dass für die Ausbildung einer hochqualitativen Titandioxidschicht diese Teilreaktion vollständig ablaufen muss, was durch einen Überschuss an Wasser begünstigt werden kann. Dabei kann als unkritisches Nebenprodukt Isopropanol abgespalten werden.

Als weitere Teilreaktion ist eine Kondensationsreaktion unter Bildung des Titandioxids zu betrachten:

Ti(OH)₄ → TiO₂ + 2H₂O

Diese Teilreaktion ist durch erhöhte Temperaturen zur Abspaltung des Wassers begünstigt.

Zur Abspaltung des Wassers und um die Kondensation von Wasser zu vermeiden, sollten die zu beschichtenden Substrate so vorgewärmt werden, dass sie eine Temperatur im Bereich 100 °C bis 250 °C aufweisen. Diese Temperatur sollte zumindest an der zu beschichtenden Oberfläche erreicht sein.

Eine Vorrichtung zur Zuführung der Gase und ein zu beschichtendes Substrat können relativ zueinander bewegt werden, um größere Flächen zu beschichten bzw. eine vorgegebene Struktur einer Titandioxidschicht auf einer Oberfläche auszubilden. Dabei kann mit der Wahl der Vorschubgeschwindigkeit auch Einfluss auf die Schichtdicke der Schicht genommen werden. Es können auch mehrere einzelne Titandioxidschichten übereinander auf der Substratoberfläche ausgebildet werden.

Auch eine Vorrichtung zur Zuführung der Gase sollte erwärmt sein. Dabei sollte die Temperatur so hoch gehalten sein, dass weder Wasserdampf noch die gasförmige Titanverbindung innerhalb der Vorrichtung kondensieren kann.

Vorteilhaft ist es beim erfindungsgemäßen Verfahren, dass lediglich Energie erforderlich ist, um die zwei für die Gasphasen-Hydrolyse erforderlichen Komponenten gasförmig zu halten und das Substrat vorzuwärmen. Es ist keine Reduzierung des Arbeitsdruckes erforderlich und es kann im Bereich des normalen Atmosphärendrucks (1 bar) gearbeitet werden.

Es können große Oberflächen beschichtet werden. Es ist nicht erforderlich, dass eine zu beschichtende Oberfläche eben bzw. weitestgehend eben ausgebildet ist. So besteht die Möglichkeit mit einer hierfür geeigneten Vorrichtung zur Zuführung der Gase auch dreidimensional geformte Oberflächen, Hohlräume oder auch Rohre innen zu beschichten.

Es kann auf eine mechanische und auch thermische Nachbehandlung verzichtet werden. Ein Einsatz eines mit dem Verfahren beschichteten Substrats ist unmittelbar nach der Ausbildung der Titandioxidschicht möglich. Eine Bildung von Pulver trat bei der Durchführung des erfindungsgemäßen Verfahrens nicht auf.

Die mit der Erfindung erhaltenen photokatalytisch aktiven Titandioxidschichten erreichen im Vergleich zu auf andere Art und Weise hergestellte Titandioxidschichten sehr gute photokatalytische Wirksamkeit. So kann eine Stearinabbaurate oberhalb 40 nm/h bei Bestrahlung mit elektromagnetischer Strahlung einer Wellenlänge von 366 nm erreicht werden. Die erfindungsgemäß hergestellten Schichten sind mit einer Abnahme des Wasserkontaktwinkels von 70° auf 10° innerhalb eines Zeitraums von 6 min bei Bestrahlung mit einer Wellenlänge von 254 nm sehr hydrophil. Der optische Brechungsindex liegt zwischen 2 und 2,6 bei kleinem erreichten Extinktionskoeffizienten. Die erhaltenen Schichten sind an der Oberfläche sehr glatt. So konnte bei einer erfindungsgemäß hergestellten Titandioxidschicht auf einem Silicium-Wafer, als Substrat, eine Rauheit Rₐ = 3,9 nm ermittelt werden. Die Schichten wiesen eine gute Haftung auf und konnten mit Schichtdicken zwischen 10 und 1000 nm ausgebildet werden.

Nachfolgend soll die Erfindung beispielhaft näher erläutert werden.

Dabei zeigen:
Figur 1 in einer Teilschnittdarstellung ein Beispiel einer Vorrichtung zur Zuführung von Gasen, die bei der Durchführung des erfindungsgemäßen Verfahrens einsetzbar ist;
Figur 2 in einer Teilschnittdarstellung ein weiteres Beispiel einer Vorrichtung zur Zuführung von Gasen, die bei der Durchführung des erfindungsgemäßen Verfahrens einsetzbar ist;
Figur 3a und b in Teilschnittdarstellungen zwei weitere Beispiele einer Vorrichtung zur Zuführung von Gasen, die bei der Durchführung des erfindungsgemäßen Verfahrens einsetzbar sind;
Figur 4 ein Ramanspektrum einer mit dem erfindungsgemäßen Verfahren hergestellten photokatalytisch aktiven Titandioxidschicht und
Figur 5 ein Röntgendiffraktrogramm einer mit dem erfindungsgemäßen Verfahren hergestellten photokatalytisch aktiven Titandioxidschicht.

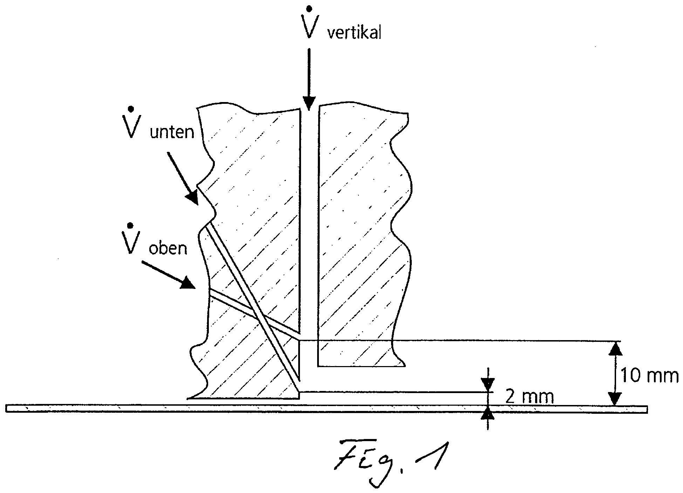

In den Figuren 1 bis 3 sind Beispiele für Vorrichtungen für eine Zufuhr von Gasen gezeigt, die beim erfindungsgemäßen Verfahren eingesetzt werden können.

Mit der Darstellung nach Figur 1 sind Möglichkeiten für eine Kanalführung verdeutlicht über die die erforderlichen Gase in Richtung Substratoberfläche zugeführt werden können. Ein Kanal ist hier vertikal ausgerichtet und seine mittlere Längsachse verläuft senkrecht zur Substratoberfläche. Durch ihn wird der Volumenstrom Vᵥₑᵣₜᵢₖₐₗ zugeführt. Dies kann allein Stickstoff als Trägergas sein. Die Austrittsöffnung kann als Schlitzdüse ausgebildet sein. Es besteht aber auch die Möglichkeit eine Vielzahl solcher Einzelkanäle in einer Reihenanordnung vorzusehen. Über die unterschiedlich schräg geneigten weiteren Kanäle können die eigentlich miteinander reagierenden Gaskomponenten zugeführt werden.

Dabei sind die Abstände der Unterkanten von Austrittsöffnungen zur Substratoberfläche dieser geneigten Kanäle in Figur 1 bemaßt. Die Kanäle über die der Volumenstrom Vᵤₙₜₑₙ geführt wird sind in Bezug zur Substratoberfläche in einem Winkel von 64° geneigt. Durch diese Kanäle mit einer Anzahl von 49 und einem Durchmesser der Austrittsöffnungen von 1 mm wurde ein Gasgemisch aus Stickstoff als Trägergas mit Wasserdampf oder TTIP mit 5 bis 20 slm zugeführt. Die Kanäle waren in einer Reihe angeordnet und hatten einen Abstand von jeweils 3 mm zueinander.

Diese Parameter treffen auch auf die anderen dargestellten Kanäle zu, über die der Volumenstrom V_{oben} zugeführt werden kann. Lediglich der Neigungswinkel war mit 30° kleiner gewählt. Es waren dabei insgesamt 50 Kanäle in einer Reihe angeordnet.

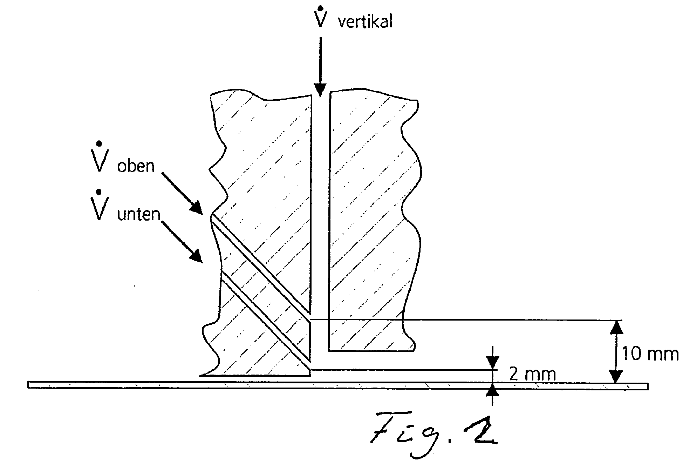

Bei der in Figur 2 gezeigten Vorrichtung sind wieder zwei Reihen von Kanälen, die übereinander angeordnet sind, gewählt worden. Diese sind jedoch im gleichen Winkel von 45° geneigt und es wurden jeweils 75 Kanäle in Abständen von jeweils 2 mm zueinander eingesetzt. Lediglich die Abstände der Austrittsöffnungen zur Substratoberfläche waren in beiden Kanalreihen unterschiedlich.

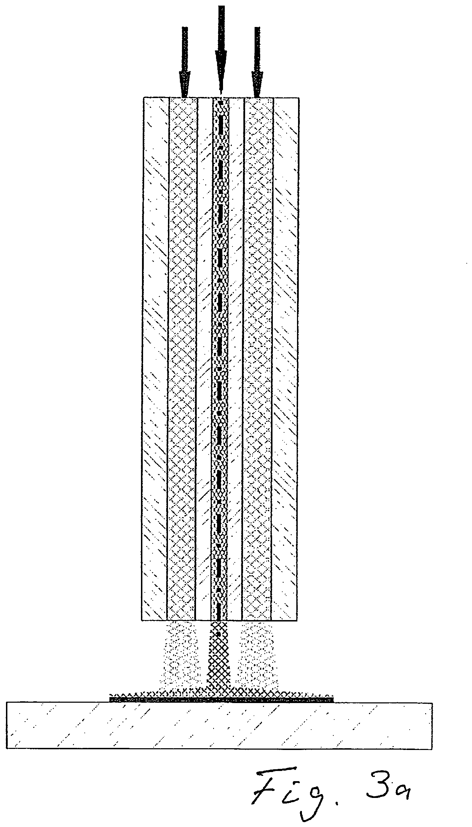

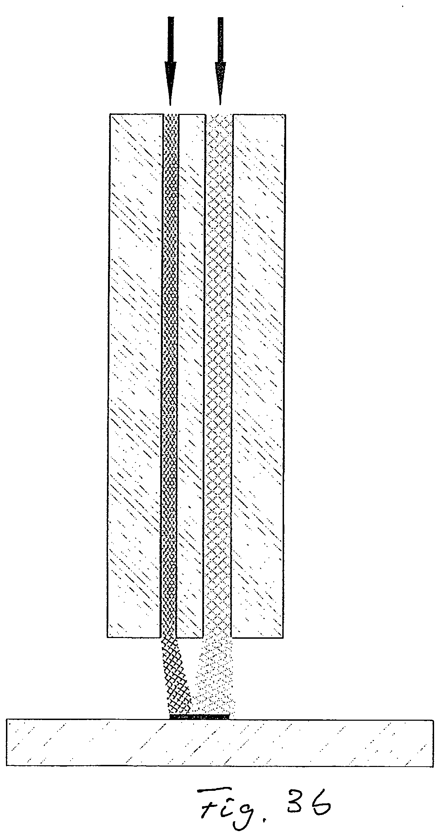

Bei den in Figuren 3a und 3b gezeigten Möglichkeiten für Vorrichtungen für eine Gaszufuhr sind mehrere parallele Kanäle vorhanden, deren Längsachsen alle senkrecht zur Substratoberfläche ausgerichtet sind.

In der Figur 3a sind es drei Kanäle oder ein Ringkanal in dessen Innerem ein weiterer mittlerer Kanal angeordnet sein kann. In der Darstellung von Figur 3b sind zwei parallele Kanäle vorhanden, die aber unterschiedliche freie innere Querschnitte aufweisen.

Bei der Vorrichtung nach Figur 1 kann durch die zwei äußeren Kanäle bzw. den Ringkanal ein Gemisch, das mit Trägergas und Wasserdampf gebildet ist und durch den zentralen Kanal TTIP allein zugeführt werden.

Bei der Darstellung in Figur 3b trifft dies sinngemäß ebenfalls zu, da dort durch den rechten Kanal mit dem größeren freien inneren Querschnitt ebenfalls Trägergas und Wasserdampf und durch den linken Kanal allein TTIP in Gasphase zugeführt werden kann. Bei beiden gezeigten Varianten liegen die Austrittsöffnungen der Kanäle in einer Ebene, so dass ein gleicher Abstand zur Substratoberfläche vorliegt. Der Abstand kann dabei verändert werden. Dies trifft auch auf eine Neigung zu. So kann eine Ausrichtung der Gasströmung an eine sich ändernde Oberflächentopografie einer dreidimensional ausgebildeten Substratoberfläche oder eine dreidimensionale Beschichtung einfach erreicht werden.

Bei Untersuchungen wurde mit Strömungsgeschwindigkeiten im Bereich 2 bis 11 m/s der Gase gearbeitet. Für eine Vorrichtung nach Figur 1 wurden die Parameter der Tabelle 1 berücksichtigt.

**Tabelle 1**

| **Anzahl der Kanäle** | **Gasfluss [slm]** | **Durchfluss/Kanal** | **Strömungsgeschwindigkeit [m/s]** | **Reynoldszahl** |
|---|---|---|---|---|
| 49 | 5 | 0,10204 | 2,1653 | 163,13 |
| | 25 | 0,5102 | 10,8268 | 815,67 |
| 50 | 5 | 0,1 | 2,12207 | 159,87 |
| | 25 | 0,5 | 10,6103 | 799,35 |

Mit den sich ergebenden Reynoldszahlen der Gasströme kann nachgewiesen werden, dass laminare Strömungsverhältnisse vorlagen, da die hierfür kritische Reynoldszahl bei weitem nicht erreicht worden ist.

Das TTIP wurde bis auf oberhalb seiner Siedetemperatur (232 °C) erwärmt und gasförmig zugeführt. Es kann aber auch eine Zuführung über einen Bubbler mit Hilfe von Trägergas erfolgen, bei der kleinere Temperaturen bis zu ca. 80 °C vorliegen.

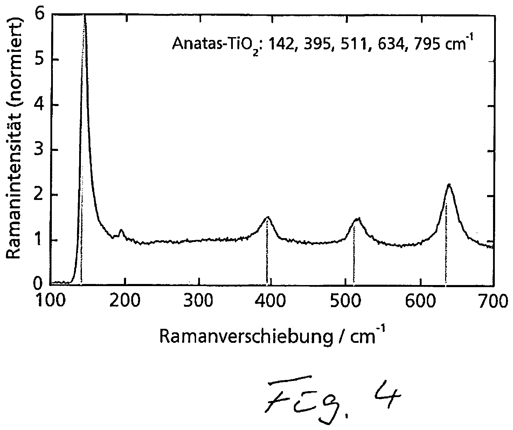

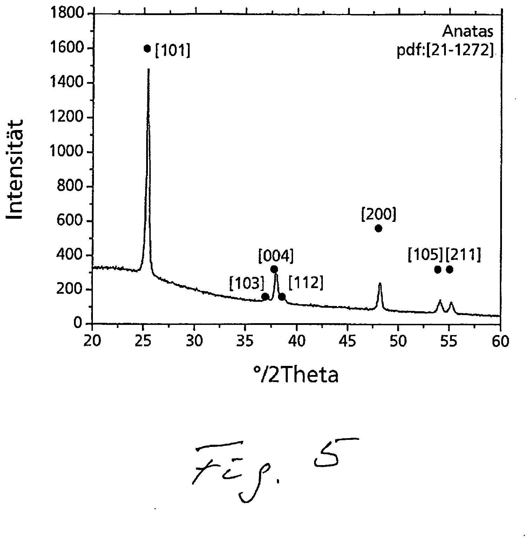

Mit den in Figuren 4 und 5 gezeigten Diagrammen wird auch der hohe Anteil an Anatas in der ausgebildeten Titandioxidschicht nachgewiesen, der für die photokatalytische Aktivität bedeutend ist.

### Beispiel 1:

Mit einer Vorrichtung, wie sie in Figur 1 gezeigt ist, wurden Titandioxidschichten ausgebildet. Eine Vorrichtung mit Gasverteilungssystem wurde über einem zu beschichtenden Substrat angeordnet und das Substrat bei der Beschichtung bewegt. Es wurden TTIP mit einem Massenstrom von 15 g/h und einem Trägergasstrom von 20 l/min als Vᵤₙₜₑₙ durch die unteren Kanäle, deren Austrittsöffnungen am nächsten zur Substratoberfläche angeordnet sind und einen Durchmesser von 1 mm aufwiesen, auf die Substratoberfläche gerichtet. Es ergab sich eine Strömungsgeschwindigkeit dieser Gasmischung von 8,66 m/s. Durch die oberen Kanäle wurde Wasser mit 19,4 g/h mit einem Trägergasstrom von 33 l/min als V_{oben} in Richtung der zu beschichtenden Oberfläche gerichtet. Da hier 50 Kanäle eingesetzt waren, deren Austrittsöffnungen ebenfalls einen Durchmesser von 1 mm aufwiesen, ergab sich eine Strömungsgeschwindigkeit dieses Gasgemisches von 14 m/s. Durch den dritten Kanal strömte Stickstoff mit 15 l/min als Vᵥₑᵣₜᵢₖₐₗ ebenfalls auf die Oberfläche.

Die Kanäle wurden auf eine Temperatur von 100 °C erwärmt.

Substrate aus Glas oder Edelstahl mit einer Dicke von 1 mm wurden auf eine Temperatur von 250 °C erwärmt. Die Beschichtung erfolgte mit 10 Zyklen, wobei ein Zyklus in eine Vorwärts- und eine Rückbewegung aufgeteilt war. Bei der Vorwärtsbewegung wurde das Substrat mit einer Geschwindigkeit von 5 mm/s und bei der Rückbewegung mit 30 mm/s bewegt. Die auf einem Substrat aus Edelstahl abgeschiedenen Titandioxidschichten wiesen einen optischen Brechungsindex von 2,43 bei einer Wellenlänge von 550 nm und einer Schichtdicke von 244 nm auf. Die Kristallinität (Anatasmodifikation) des Titandioxids konnte mittels Ramanspektroskopie nachgewiesen werden. Die photokatalytische Aktivität wurde durch die Abbaurate von Stearinsäureschichten mit einem Wert von 42,9 nm/h bei Bestrahlung mit elektromagnetischer Strahlung einer Wellenlänge von 366 nm, die von einer UV-Lampe (I= 1 mW/cm²) emittiert worden ist, linear ermittelt.

### Beispiel 2:

Mit einer Vorrichtung, wie in Figur 2 gezeigt, wurden Titandioxidschichten ausgebildet. Die Vorrichtung war über einer zu beschichtenden Substratoberfläche angebracht und konnte zweidimensional in einer X-Y-Richtung bewegt werden.

Es wurden dabei TTIP mit einem Massenstrom von 7,6 g/h in einem Trägergasstrom von 2 l/min durch die unteren mit ihrer Austrittsöffnung näher zum Substrat angeordneten Kanäle als Vᵤₙₜₑₙ zugeführt. Mit den 75 hierfür eingesetzten Kanälen, deren Austrittsöffnungen einen Durchmesser von 1 mm aufwiesen, ergab sich für diese Gasmischung eine Strömungsgeschwindigkeit von 0,56 m/s. Durch die oberen 75 Kanäle, deren Austrittsöffnungen ebenfalls einen Durchmesser von 1 mm aufwiesen, wurden 13 g/h Wasser und 4 l/min Trägergas, als V_{oben} zugeführt. Dabei ergab sich eine Strömungsgeschwindigkeit dieser Gasmischung von 1,12 m/s. Durch den vertikal ausgerichteten Kanal wurde ein Gasgemisch Argon/Stickstoff als Vᵥₑᵣₜᵢₖₐₗ mit 55 l/min zugeführt. Die Kanäle wurden auf eine Temperatur von 100 °C und zu beschichtende Substrate aus Glas oder Edelstahl mit einer Dicke von 1 mm auf eine Temperatur von 250 °C erwärmt.

Die Vorrichtung wurde mit einer Geschwindigkeit von 25 mm/s und einer Schrittweite von 1,5 mm mäanderförmig über die Substratoberfläche bewegt. Der Abstand der Vorrichtungen zur Oberfläche des Substrats wurde bei allen Beispielen während der Ausbildung der Beschichtung konstant gehalten.

Es konnten homogene Schichten erhalten werden. Die so ausgebildeten Titandioxidschichten auf Edelstahl wiesen einen optischen Brechungsindex von 2,41 bei einer Wellenlänge von 550 nm und einer Schichtdicke von 111 nm auf.

Die hohe Kristallinität (Anatasmodifikation) des Titandioxids konnte mittels Ramanspektroskopie nachgewiesen werden, wie es in Figur 4 gezeigt ist. Die photokatalytische Aktivität wurde durch die Abbaurate von Stearinsäureschichten mit einem Wert von 40,7 nm/h bei Bestrahlung mit elektromagnetischer Strahlung einer Wellenlänge von 366 nm, die von einer UV-Lampe (I= 1 mW/cm²) emittiert worden ist, linear ermittelt.

Analog beschichtete Glassubstrate wiesen Titandioxidschichten mit einem optischen Brechungsindex von 2,54 bei einer Wellenlänge von 550 nm und einer Schichtdicke von 82 nm auf. Die Kristallinität des Titandioxids wurde mittels Röntgendiffraktometrie (XRD), wie aus Figur 5 hervorgeht, nachgewiesen.

Es wurden außerdem in der vorab erläuterten Form erhaltenen Titandioxidschichten Untersuchungen durchgeführt, wobei die Ausbildung der Schichten auf Substraten erfolgte, die auf eine Temperatur von nur 100 °C erwärmt worden waren. Dabei wurden Substrate aus Glas, Edelstahl, Aluminium, Papier und Polymeren beschichtet. Bei Schichtdicken von 95 nm wurde ein optischer Brechungsindex von 1,99 bei λ= 550 nm erreicht. Die Titandioxidschichten wiesen ebenfalls photokatalytische Aktivität auf, was durch Farbwechsel beim Resazurintinten-Test nachweisbar war. Sie waren Superhydrophil. Bei Titandioxidschichten auf Glas konnte eine Abbaurate von Stearinssäure von 2,3 nm/h ermittelt werden.

## Patentansprüche

1. Verfahren zur Herstellung photokatalytisch aktiver Titandioxidschichten mittels Gasphasen-Hydrolyse, bei dem eine Gasphase bestehend aus einer Titanverbindung und Wasserdampf oder zusätzlich oder im Gemisch mit einem inerten Trägergas auf ein vor erwärmtes Substrat gerichtet wird und durch chemische Reaktion eine Titandioxidschicht auf der Oberfläche des Substrates ausgebildet wird; dabei werden die Titanverbindung und Wasserdampf voneinander getrennt zugeführt, wobei
die Zufuhr von Titanverbindung und Wasserdampf bis kurz vor dem Auftreffen auf die Oberfläche getrennt und dabei so erfolgt, dass eine Strömungsgeschwindigkeit von mindestens 0,5 m/s erreicht und die Zeit zwischen dem ersten Kontakt der beiden Gase bis zum Auftreffen auf die Oberfläche des Substrates kleiner 0,05 s gehalten wird und dabei die photokatalytisch aktive Titandioxidschicht auf der Substratoberfläche ausgebildet wird.

2. Verfahren nach Anspruch 1, **dadurch gekennzeichnet, dass** als Titanverbindung Tetraisopropylorthotitanat (TTIP) eingesetzt wird.

3. Verfahren nach einem der vorhergehenden Ansprüche, **dadurch gekennzeichnet, dass** Wasserdampf im Überschuss zugeführt wird.

4. Verfahren nach einem der vorhergehenden Ansprüche, **dadurch gekennzeichnet, dass** das Substrat auf eine Temperatur im Bereich 100 °C bis 250 °C erwärmt wird.

5. Verfahren nach einem der vorhergehenden Ansprüche, **dadurch gekennzeichnet, dass** die Gase als laminare Strömung auf die Substratoberfläche gerichtet werden.

6. Verfahren nach einem der vorhergehenden Ansprüche, **dadurch gekennzeichnet, dass** die Gase mit einer Strömungsgeschwindigkeit von mindestens 2 m/s auf die Substratoberfläche gerichtet und Zeit zwischen dem ersten Kontakt der beiden Gase bis zum Auftreffen auf die Oberfläche des Substrates kleiner 0,001 s gehalten wird.

7. Verfahren nach einem der vorhergehenden Ansprüche, **dadurch gekennzeichnet, dass** ein Mol-Verhältnis von mindestens 2 zu 1 für Wasser und Titanverbindung eingehalten wird.

8. Verfahren nach einem der vorhergehenden Ansprüche, **dadurch gekennzeichnet, dass** eine Vorrichtung zur Zuführung der Gase und ein Substrat relativ zueinander bewegt werden.

9. Verfahren nach einem der vorhergehenden Ansprüche, **dadurch gekennzeichnet, dass** die Vorrichtung zur Zuführung der Gase auf eine Temperatur oberhalb der Kondensationstemperatur der zugeführten Gase erwärmt wird.

10. Verfahren nach einem der vorhergehenden Ansprüche, **dadurch gekennzeichnet, dass** die Ausbildung der Titandioxidschicht im Bereich des Atmosphärendrucks durchgeführt wird.

## Claims

1. Process for producing photocatalytically active titanium dioxide layers by gas-phase hydrolysis, wherein a gas phase consisting of a titanium compound and water vapour or additionally of or in a mixture with an inert carrier gas is directed onto a preheated substrate and by chemical reaction a titanium dioxide layer is formed on the surface of the substrate, the titanium compound and water vapour being supplied separately from one another, and the supply of titanium compound and water vapour taking place separately until shortly before the impingement on the surface and in such a way that a flow rate of at least 0.5 m/s is attained and the time between the first contact of the two gases up to the impingement on the surface of the substrate is kept less than 0.05 s and the photocatalytically active titanium dioxide layer here is formed on the substrate surface.

2. Method according to Claim 1, **characterized in that** tetraisopropyl orthotitanate (TTIP) is used as titanium compound.

3. Method according to either of the preceding claims, **characterized in that** water vapour is supplied in excess.

4. Method according to any of the preceding claims, **characterized in that** the substrate is heated to a temperature in the range 100°C to 250°C.

5. Method according to any of the preceding claims, **characterized in that** the gases are directed as a laminar flow onto the substrate surface.

6. Method according to any of the preceding claims, **characterized in that** the gases directed with a flow rate of at least 2 m/s onto the substrate surface and time between the first contact of the two gases up to the impingement on the surface of the substrate is kept less than 0.001 s.

7. Method according to any of the preceding claims, **characterized in that** a molar ratio of at least 2:1 is observed for water and titanium compound.

8. Method according to any of the preceding claims, **characterized in that** an apparatus for supplying the gases and a substrate are moved relative to one another.

9. Method according to any of the preceding claims, **characterized in that** the apparatus for supplying the gases is heated to a temperature above the condensation temperature of the gases supplied.

10. Method according to any of the preceding claims, **characterized in that** the forming of the titanium dioxide layer is carried out in the region of atmospheric pressure.

## Revendications

1. Procédé de fabrication de couches de dioxyde de titane photocatalytiquement actives par hydrolyse en phase gazeuse, dans lequel une phase gazeuse, constituée d'un composé du titane et de vapeur d'eau, ou en outre ou en mélange avec un gaz porteur inerte, est envoyée sur un substrat préchauffé et, par réaction chimique, il y a formation d'une couche de dioxyde de titane sur la surface du substrat ; le composé du titane et la vapeur d'eau sont à cette occasion amenés séparément l'un de l'autre, l'ajout du composé du titane et de la vapeur d'eau s'effectuant séparément jusqu'à peu de temps avant de heurter la surface, et étant réalisé de façon à atteindre une vitesse d'écoulement d'au moins 0,5 m/s et à maintenir inférieur à 0,05 s le temps entre le premier contact des deux gaz et l'impact sur la surface du substrat, la couche de dioxyde de titane photocatalytiquement active se formant alors sur la surface du substrat.

2. Procédé selon la revendication 1, **caractérisé en ce qu'**on utilise en tant que composé du titane l'orthotitanate de tétraisopropyle (TTIP).

3. Procédé selon l'une des revendications précédentes, **caractérisé en ce que** la vapeur d'eau est amenée en excès.

4. Procédé selon l'une des revendications précédentes, **caractérisé en ce que** le substrat est chauffé à une température dans la plage de 100 °C à 250 °C.

5. Procédé selon l'une des revendications précédentes, **caractérisé en ce que** les gaz sont envoyés sur la surface du substrat sous forme d'un écoulement laminaire.

6. Procédé selon l'une des revendications précédentes, **caractérisé en ce que** les gaz sont envoyés sur la surface du substrat à une vitesse d'écoulement d'au moins 2 m/s, et le temps entre le premier contact des deux gaz et l'impact sur la surface du substrat est inférieur à 0,001 s.

7. Procédé selon l'une des revendications précédentes, **caractérisé en ce qu'**on maintient un rapport en moles d'au moins 2:1 entre l'eau et le composé du titane.

8. Procédé selon l'une des revendications précédentes, **caractérisé en ce qu'**on déplace l'un par rapport à l'autre un dispositif pour l'amenée des gaz et un substrat.

9. Procédé selon l'une des revendications précédentes, **caractérisé en ce que** le dispositif pour l'amenée des gaz est chauffé à une température supérieure à la température de condensation des gaz amenés.

10. Procédé selon l'une des revendications précédentes, **caractérisé en ce que** la formation de la couche de dioxyde de titane est mise en œuvre dans le domaine de la pression atmosphérique.
